# EUROPEAN PATENT APPLICATION

(11) **EP 4 557 353 A2**
(43) Date of publication of application: **21.05.2025**
(21) Application number: 24213114.2
(22) Date of filing: 14.11.2024
(51) Int. Cl.: H01L 21/56, H01L 23/04, H01L 21/60, H01L 23/552

(54) **SEMICONDUCTOR DEVICE HAVING INTEGRATED LID STRUCTURE AND METHOD THEREFOR**

(30) Priority: 15.11.2023 US 202318509642
(71) Applicant: NXP B.V., 5656 AG Eindhoven (NL)
(72) Inventor: TSAI, Yu Ling, 5656 AG Eindhoven (NL); LIN, Yen-Chih, 5656 AG Eindhoven (NL); TSAI, Yi-Hsuan, 5656 AG Eindhoven (NL); CHANG, Yao Jung, 5656 AG Eindhoven (NL)
(74) Representative: Hardingham, Christopher Mark

(57) **Abstract**

A semiconductor device having an integrated lid structure is provided. The method includes mounting a semiconductor die within a cavity of a lid structure. An active side of the semiconductor die is substantially coplanar with a bottom surface of the lid structure. An encapsulant substantially fills a gap region between sidewalls of the semiconductor die and inner sidewall surfaces of the cavity.

## Description

### Background

### Field

This disclosure relates generally to semiconductor device packaging, and more specifically, to a semiconductor device having an integrated lid structure and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. With such features and applications, the configuration of the semiconductor device packages may limit performance of the semiconductor devices or impact the costs of the semiconductor devices. Accordingly, significant challenges exist in accommodating these features and applications while minimizing the impact on semiconductor devices' performance and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified bottom-side-up plan view, an example semiconductor device having an integrated lid structure at a stage of manufacture in accordance with an embodiment.
FIG. 2 illustrates, in a simplified side view, the example semiconductor device at the stage of manufacture depicted in FIG. 1 in accordance with an embodiment.
FIG. 3 through FIG. 5 illustrate, in simplified bottom-side-up plan views, the example semiconductor device at subsequent stages of manufacture in accordance with an embodiment.
FIG. 6 illustrates, in a simplified cross-sectional view, the example semiconductor device at the stage of manufacture depicted in FIG. 5 taken along line A-A in accordance with an embodiment.
FIG. 7 illustrates, in a simplified cross-sectional view, the example semiconductor device taken along line A-A of FIG. 5 at a subsequent stage of manufacture in accordance with an embodiment.

### Detailed Description

Generally, there is provided, a semiconductor device having an integrated lid structure. The semiconductor device includes a semiconductor die mounted in a cavity of the lid structure such that sidewalls of the lid substantially surround sidewalls of the semiconductor die. A backside of the semiconductor die is affixed to the bottom of the cavity by way of a thermally conductive adhesive. The mounted semiconductor die and lid structure are at least partially encapsulated with an encapsulant. A first portion of the encapsulant the surrounds an outer perimeter of the lid structure and a second portion of the encapsulant substantially fills a gap region of the cavity between the semiconductor die and sidewalls of the cavity. After encapsulation, top and bottom surfaces of the lid structure are exposed, and an active side of the semiconductor die is exposed. A plurality of conductive connectors 616 (e.g., solder balls) are affixed to respective the die pads 404. The conductive connectors 616 are configured and arranged to provide conductive connections between the semiconductor device 100 and a printed circuit board (PCB), for example. A plurality of conductive connectors (e.g., solder balls) are affixed to respective die pads of the semiconductor die. The conductive connectors are configured and arranged to provide conductive connections between the semiconductor device and a printed circuit board, for example. The semiconductor device may be characterized as a high-performance or high-power flip-chip ball grid array (HFCBGA) type device. By forming the semiconductor device in this manner, the integrated lid structure provides enhanced thermal dissipation, electromagnetic interference (EMI) shielding, and warpage control.

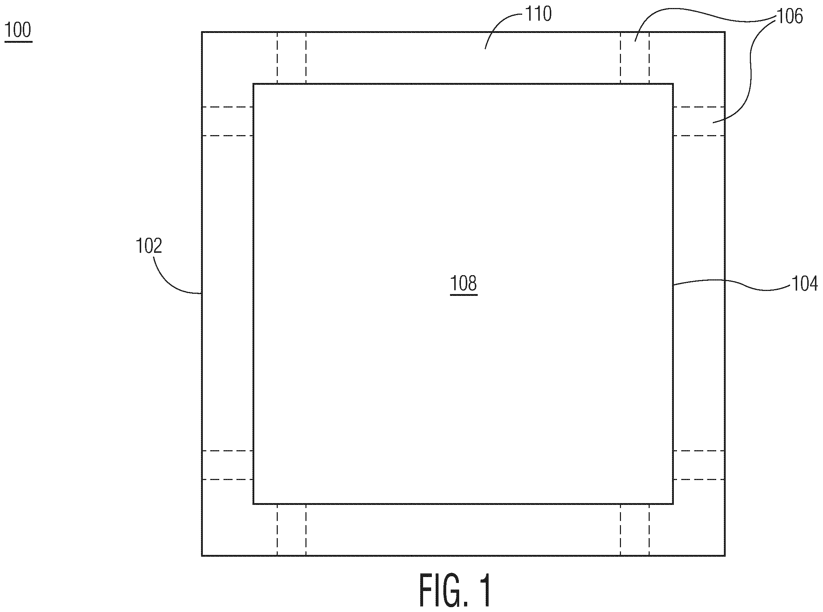

FIG. 1 illustrates, in a simplified bottom-side-up plan view, an example semiconductor device 100 having an integrated lid structure at a stage of manufacture in accordance with an embodiment. At this stage, the semiconductor device 100 includes a lid structure 102. A cavity 104 is formed in the lid structure 102. The cavity includes a bottom surface 108 surrounded by sidewalls of the lid structure 102. In this embodiment, a plurality of grooves (e.g., channels) 106 (indicated by dashed lines) are formed at the bottom surface 110 of the sidewall portions of the lid structure 102. The grooves 106 are configured to allow an encapsulant material (e.g., epoxy mold compound) to flow into and through the cavity 104 as desired during an encapsulation operation at a subsequent stage of manufacture, for example. In this embodiment, the lid structure is formed from a metal material such as copper, aluminum, and the like. The metal material and thickness of the lid structure 102 may be chosen for desired thermal dissipation, electromagnetic interference (EMI) shielding, and warpage control characteristics, for example. The size and shape of the lid structure 102 and corresponding cavity 104 along with the number and locations of the grooves 106 depicted in FIG. 1 are chosen for illustration purposes.

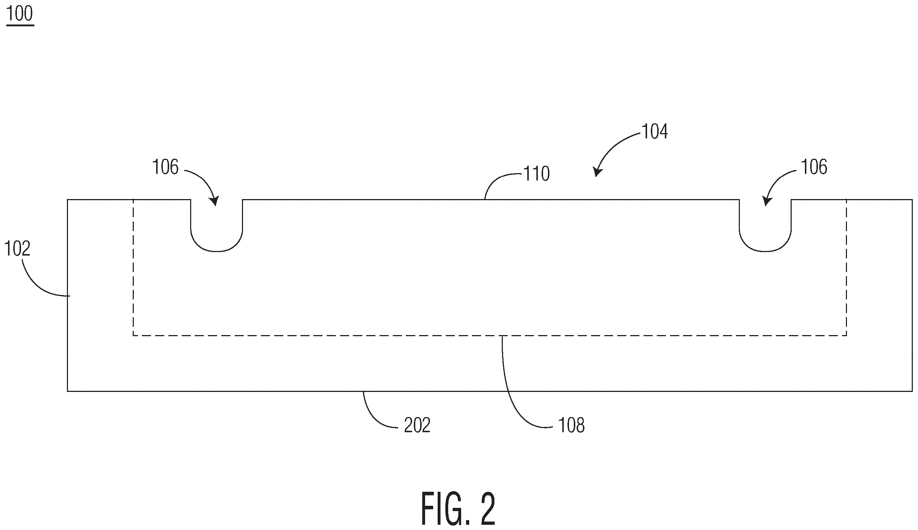

FIG. 2 illustrates, in a simplified bottom-side-up side view, the example semiconductor device 100 having an integrated lid structure at the stage of manufacture depicted in FIG. 1 in accordance with an embodiment. A side portion of the lid structure 102 is illustrated in FIG. 2. The cavity 104 of the lid structure 102 including the bottom surface 108 of the cavity are shown as dashed lines for reference. In this embodiment, the plurality of grooves 106 are located at the bottom surface 110 of the sidewall portions of the lid structure 102. As depicted in FIG. 2, the lid structure 102 is arranged in a bottom side up orientation with the top surface 202 of the lid structure 102 located at the bottom of the illustration.

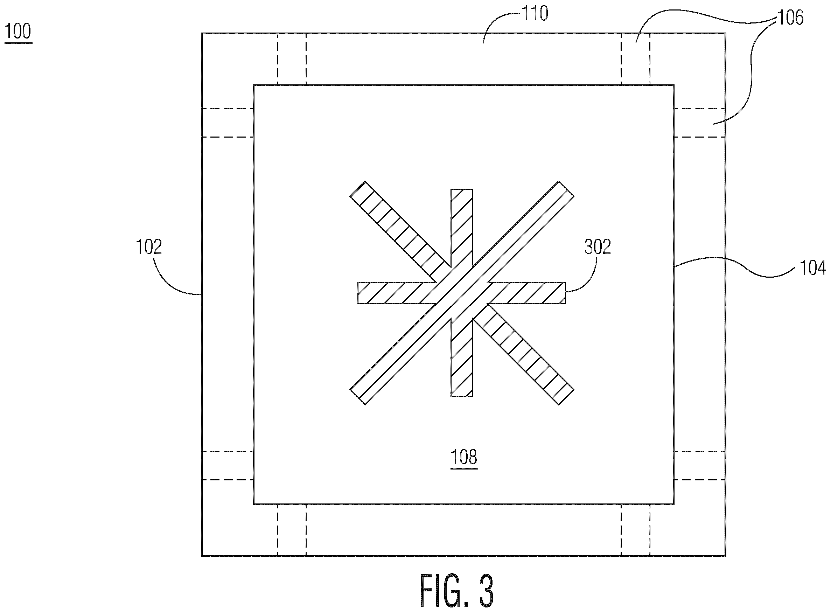

FIG. 3 illustrates, in a simplified bottom-side-up plan view, the example semiconductor device 100 having an integrated lid structure at a subsequent stage of manufacture in accordance with an embodiment. At this stage, the semiconductor device 100 includes a thermally conductive adhesive 302 applied on the bottom surface 108 of the cavity 104. Thermally conductive adhesive 302 may be applied as a tape or film or otherwise dispensed onto the bottom surface 108 of the cavity 104. In this embodiment, the thermally conductive adhesive 302 is chosen for consistent, uniform, and accurate bondline thickness (BLT) characteristics when bonding a semiconductor die at a subsequent stage of manufacture, for example.

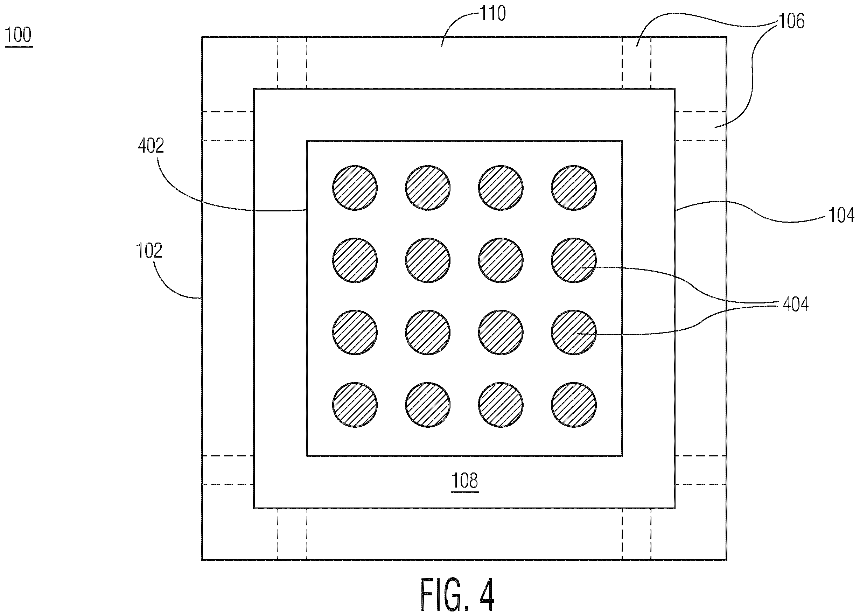

FIG. 4 illustrates, in a simplified bottom-side-up plan view, the example semiconductor device 100 having an integrated lid structure at a subsequent stage of manufacture in accordance with an embodiment. At this stage, the semiconductor device 100 includes a semiconductor die 402 mounted within the cavity 104 of the lid structure 102. In this embodiment, the semiconductor die 402 is affixed to the bottom surface 108 of the cavity 104 by way of the thermally conductive adhesive 302 applied on the bottom surface. By utilizing the thermally conductive adhesive 302 for mounting the semiconductor die 402 in this manner, desired consistent, uniform, and accurate BLT can be realized. These desired BLT characteristics may be critical to the reliability of high performance and high power devices, for example.

The semiconductor die 402 has an active side (e.g., major side having circuitry, die pads) and a backside (e.g., major side opposite of the active side). In this embodiment, the backside of the semiconductor die 402 is mounted the bottom surface 108 of the cavity 104 while die pads 404 at the active side of the semiconductor die 402 are exposed, for example. In this embodiment, the semiconductor die 402 is configured in a flip-chip orientation having the die pads 404 at the active side arranged for attachment of conductive connectors (e.g., solder balls) at a subsequent stage of manufacture. In this embodiment, the active side of the semiconductor die 402 is substantially coplanar with the bottom surface 110 of the sidewall portions of the lid structure 102. The semiconductor die 402 may be formed from any suitable semiconductor material, such as silicon, germanium, gallium arsenide, gallium nitride, and the like. The semiconductor die 402 may further include any digital circuits, analog circuits, RF circuits, power circuits, memory, processor, MEMs, sensor, the like, and combinations thereof at the active side.

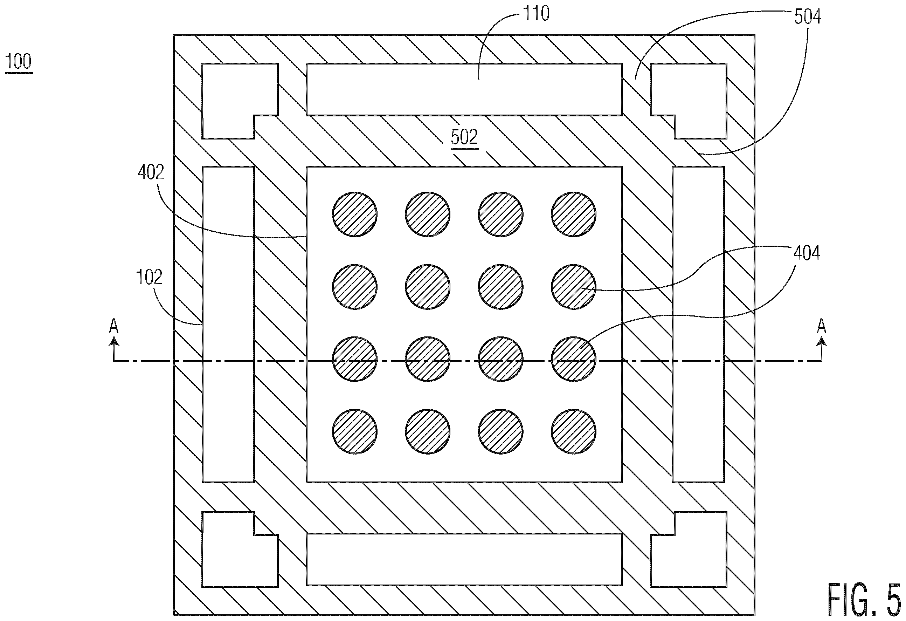

FIG. 5 illustrates, in a simplified bottom-side-up plan view, the example semiconductor device 100 having an integrated lid structure at a subsequent stage of manufacture in accordance with an embodiment. At this stage, the semiconductor device 100 includes the semiconductor die 402 and the lid structure 102 at least partially encapsulated with an encapsulant 502 (e.g., epoxy molding compound). In this embodiment, the semiconductor die 402 and the lid structure 102 are molded with the encapsulant 502 by way of a molding process. The encapsulant 502 may be an epoxy molding compound dispensed during an injection molding encapsulation operation, for example. Alternatively, the semiconductor die 402 and the lid structure 102 may be molded with the encapsulant 502 by way of a film-assisted molding (FAM) process. For example, a FAM tool using a conformal film may be engaged with predetermined portions of the semiconductor die 402 and the lid structure 102 during the molding process to keep the predetermined portions exposed and free from encapsulant.

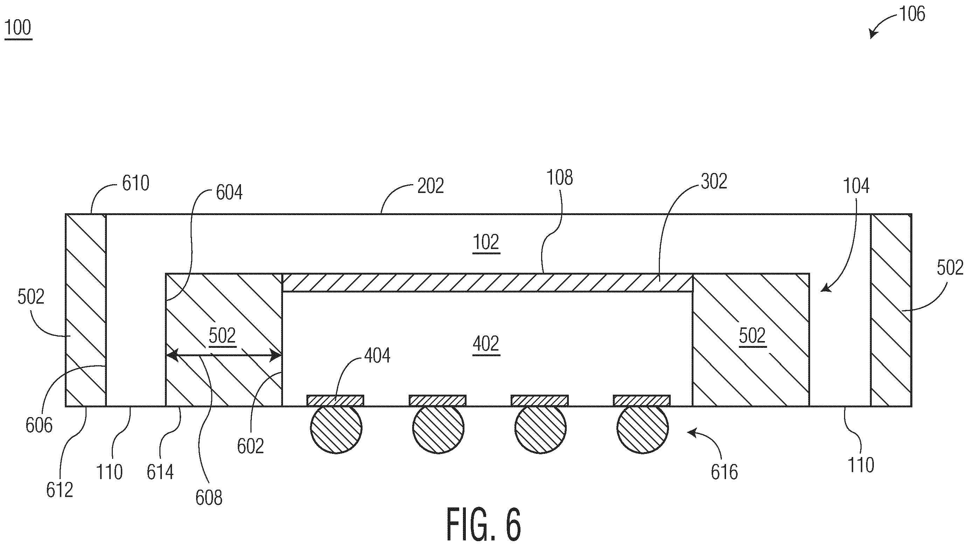

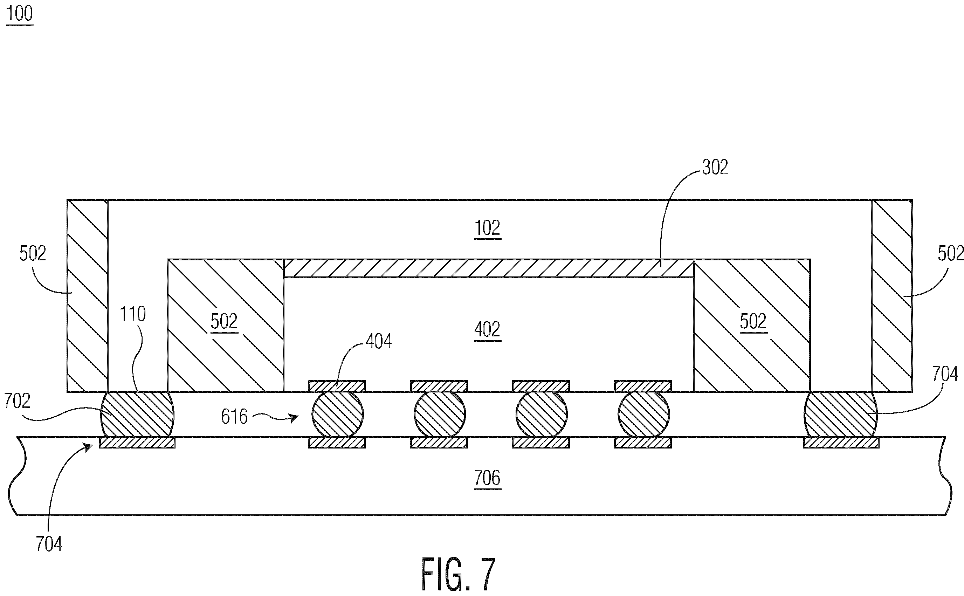

In this embodiment, the encapsulant 502 surrounds an outer perimeter of the lid structure and substantially fills a gap region of the cavity between the semiconductor die 402 and sidewalls of the cavity. A portion 504 of the encapsulant fills the grooves 106 of FIG. 4 formed at the bottom surface 110 of the sidewall portions of the lid structure 102. In this embodiment, the bottom surface 110 of the sidewall portions of the lid structure 102 and the active side of the semiconductor die 402 including the die pads 404 are exposed through the encapsulant 502 after the molding process. Cross-sectional views of the example semiconductor device 100 taken along line A-A of FIG. 5 at stages of manufacture are depicted in FIG. 6 and FIG. 7.

FIG. 6 illustrates, in a simplified top-side-up cross-sectional view, the example semiconductor device 100 having an integrated lid structure at the stage of manufacture depicted in FIG. 5 in accordance with an embodiment. At this stage, the semiconductor device 100 includes the semiconductor die 402 and the lid structure 102 at least partially encapsulated with the encapsulant 502. In this embodiment, the encapsulant 502 surrounds an outer sidewall surface 608 of the lid structure and substantially fills a gap region 608 of the cavity between sidewalls 602 of the semiconductor die 402 and inner sidewall surfaces 604 of the cavity 104. In this embodiment, the bottom surface 110 of the sidewall portions of the lid structure 102 and the active side of the semiconductor die 402 including the die pads 404 are exposed through the encapsulant 502 at the bottom side of the semiconductor device 100 after the molding process. Likewise, the top surface 202 of the lid structure 102 is exposed through the encapsulant 502 at the top side of the semiconductor device 100 after the molding process. A plurality of conductive connectors 616 (e.g., solder balls) are affixed to respective the die pads 404. The conductive connectors 616 are configured and arranged to provide conductive connections between the semiconductor device 100 and a printed circuit board (PCB), for example. The conductive connectors 616 may be in the form of any suitable conductive structures such as solder balls, gold studs, copper pillars, and the like, to connect conductive features of the semiconductor device 100 with the PCB. As an alternative to attaching conductive connectors 616, the die pads 404 may be subsequent connected to the PCB by way of solder paste attachment or other suitable conductive attachment processes (e.g., ACF, ACP).

In this embodiment, a top surface 610 of the encapsulant 502 surrounding the outer sidewall surface 608 of the lid structure 102 is substantially coplanar with the top surface 202 of the lid structure, and a bottom surface 612 of the encapsulant 502 surrounding the outer sidewall surface 608 of the lid structure 102 is substantially coplanar with the bottom surface 110 of the lid structure. Likewise, the bottom surface 612 of the encapsulant 502 surrounding the outer sidewall surface 608 of the lid structure 102 is substantially coplanar with the bottom surface 614 of the encapsulant 502 filling the gap region 608 of the cavity between sidewalls 602 of the semiconductor die 402 and the inner sidewall surfaces 604 of the cavity 104. And likewise, the active side of the semiconductor die 402 is substantially coplanar with the bottom surface 110 of the lid structure 102.

FIG. 7 illustrates, in a simplified top-side-up cross-sectional view, the example semiconductor device 100 having an integrated lid structure at subsequent stage of manufacture in accordance with an embodiment. At this stage, the semiconductor device 100 includes the encapsulated semiconductor die 402 and the lid structure 102 mounted on an example printed circuit board (PCB) 706. In this embodiment, the plurality of conductive connectors 616 are affixed to respective connector pads 704 and configured to provide conductive connections between the die pads 404 and respective connector pads 704 of the PCB 706. Likewise, the bottom surface 110 of the lid structure 102 is affixed to respective connector pads 704 by way of a conductive material 702 such as a solder paste or conductive adhesive material. For illustration purposes, the conductive connectors 616 are formed as ball connectors and arranged in a ball grid array. The term "conductive," as used herein, generally refers to electrical conductivity unless otherwise described.

Generally, there is provided, a method including mounting a semiconductor die within a cavity of a lid structure, an active side of the semiconductor die substantially coplanar with a bottom surface of the lid structure; and encapsulating with an encapsulant to substantially fill a gap region between sidewalls of the semiconductor die and inner sidewall surfaces of the cavity. A top surface of the lid structure and the bottom surface of the lid structure may be exposed after encapsulating with the encapsulant. The encapsulating with the encapsulant may further include an outer region of the encapsulant surrounding outer sidewall surfaces of the lid structure. A bottom surface of the outer region of the encapsulant may be substantially coplanar with a bottom surface of the encapsulant in the gap region. A top surface of the outer region of the encapsulant may be substantially coplanar with a top surface of the lid structure. The method may further include dispensing a thermally conductive adhesive on a bottom surface of the cavity of the lid structure before mounting the semiconductor die. The mounting the semiconductor die within the cavity may include affixing a backside of the semiconductor die to the bottom surface of the cavity by way of the thermally conductive adhesive. The lid structure may be formed from a metal material, a plurality of grooves formed at the bottom surface of the lid structure. The plurality of grooves formed at the bottom surface of the lid structure may be configured to allow encapsulant to flow into the cavity.

In another embodiment, there is provided, a semiconductor device including a lid structure having a top surface and outer sidewall surfaces; a cavity formed in the lid structure, the cavity having a bottom surface and inner sidewall surfaces; a semiconductor die mounted within the cavity such that the inner sidewall surfaces of the cavity surround the semiconductor die; and an encapsulant substantially filling a gap region between sidewalls of the semiconductor die and the inner sidewall surfaces of the cavity. An active side of the semiconductor die may be substantially coplanar with a bottom surface of the lid structure. A top surface of the lid structure and the bottom surface of the lid structure may be exposed through the encapsulant. The encapsulant may include an outer region encapsulating outer sidewall surfaces of the lid structure. A bottom surface of the outer region of the encapsulant may be substantially coplanar with a bottom surface of the encapsulant in the gap region. The lid structure may include a plurality of grooves formed at the bottom surface of the lid structure, the plurality of grooves configured to allow encapsulant to flow into the cavity during an encapsulation operation.

In yet another embodiment, there is provided, a method including providing a lid structure having a top surface and outer sidewall surfaces, the lid structure including a cavity having a bottom surface and inner sidewall surfaces; mounting a semiconductor die within the cavity such that the inner sidewall surfaces of the cavity surround the semiconductor die; and encapsulating with an encapsulant to substantially fill a gap region between sidewalls of the semiconductor die and the inner sidewalls of the cavity. An active side of the semiconductor die may be substantially coplanar with a bottom surface of the lid structure after mounting the semiconductor die. A top surface of the lid structure and the bottom surface of the lid structure may be exposed after encapsulating with the encapsulant. The encapsulating with the encapsulant may further include an outer region of the encapsulant surrounding outer sidewall surfaces of the lid structure. The lid structure may include a plurality of grooves formed at the bottom surface of the lid structure, the plurality of grooves configured to allow encapsulant to flow into the cavity.

By now, it should be appreciated that there has been provided a semiconductor device having an integrated lid structure. The semiconductor device includes a semiconductor die mounted in a cavity of the lid structure such that sidewalls of the lid substantially surround sidewalls of the semiconductor die. A backside of the semiconductor die is affixed to the bottom of the cavity by way of a thermally conductive adhesive. The mounted semiconductor die and lid structure are at least partially encapsulated with an encapsulant. A first portion of the encapsulant the surrounds an outer perimeter of the lid structure and a second portion of the encapsulant substantially fills a gap region of the cavity between the semiconductor die and sidewalls of the cavity. After encapsulation, top and bottom surfaces of the lid structure are exposed, and an active side of the semiconductor die is exposed. A plurality of conductive connectors 616 (e.g., solder balls) are affixed to respective the die pads 404. The conductive connectors 616 are configured and arranged to provide conductive connections between the semiconductor device 100 and a printed circuit board (PCB), for example. A plurality of conductive connectors (e.g., solder balls) are affixed to respective die pads of the semiconductor die. The conductive connectors are configured and arranged to provide conductive connections between the semiconductor device and a printed circuit board, for example. The semiconductor device may be characterized as a high-performance or high-power flip-chip ball grid array type device. By forming the semiconductor device in this manner, the integrated lid structure provides enhanced thermal dissipation, electromagnetic interference shielding, and warpage control.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
mounting a semiconductor die within a cavity of a lid structure, an active side of the semiconductor die substantially coplanar with a bottom surface of the lid structure; and
encapsulating with an encapsulant to substantially fill a gap region between sidewalls of the semiconductor die and inner sidewall surfaces of the cavity.

2. The method of claim 1, wherein a top surface of the lid structure and the bottom surface of the lid structure are exposed after encapsulating with the encapsulant.

3. The method of claim 1, wherein encapsulating with the encapsulant further includes an outer region of the encapsulant surrounding outer sidewall surfaces of the lid structure.

4. The method of claim 3, wherein a bottom surface of the outer region of the encapsulant is substantially coplanar with a bottom surface of the encapsulant in the gap region.

5. The method of claim 3, wherein a top surface of the outer region of the encapsulant is substantially coplanar with a top surface of the lid structure.

6. The method of claim 1, further comprising dispensing a thermally conductive adhesive on a bottom surface of the cavity of the lid structure before mounting the semiconductor die.

7. The method of claim 6, wherein mounting the semiconductor die within the cavity includes affixing a backside of the semiconductor die to the bottom surface of the cavity by way of the thermally conductive adhesive.

8. The method of claim 1, wherein the lid structure is formed from a metal material, a plurality of grooves formed at the bottom surface of the lid structure.

9. The method of claim 8, wherein the plurality of grooves formed at the bottom surface of the lid structure are configured to allow encapsulant to flow into the cavity.

10. A method comprising:
providing a lid structure having a top surface and outer sidewall surfaces, the lid structure including a cavity having a bottom surface and inner sidewall surfaces;
mounting a semiconductor die within the cavity such that the inner sidewall surfaces of the cavity surround the semiconductor die; and
encapsulating with an encapsulant to substantially fill a gap region between sidewalls of the semiconductor die and the inner sidewalls of the cavity.

11. The method of claim 10, wherein an active side of the semiconductor die is substantially coplanar with a bottom surface of the lid structure after mounting the semiconductor die.

12. The method of claim 10 or 11, wherein a top surface of the lid structure and the bottom surface of the lid structure are exposed after encapsulating with the encapsulant.

13. The method of any of claims 10 to 12, wherein encapsulating with the encapsulant further includes an outer region of the encapsulant surrounding outer sidewall surfaces of the lid structure.

14. The method of any of claims 10 to 13, wherein the lid structure includes a plurality of grooves formed at the bottom surface of the lid structure, the plurality of grooves configured to allow encapsulant to flow into the cavity.
